# EUROPÄISCHE PATENTANMELDUNG

(11) **EP 4 632 782 A1**
(43) Veröffentlichungstag der Anmeldung: **15.10.2025**
(21) Anmeldenummer: 24169723.4
(22) Anmeldetag: 11.04.2024
(51) Int. Cl.: H01H 59/00, H01H 1/00, B81B 3/00

(54) **VORRICHTUNG UND VERFAHREN ZUR DETEKTION VON SPANNUNGSEREIGNISSEN IN EINEM ELEKTRISCHEN BAUTEIL**

(71) Anmelder: Siemens Aktiengesellschaft, 80333 München (DE)
(72) Erfinder: Kriegel, Kai, 81739 München (DE); Raab, Oliver, 94496 Ortenburg (DE); Santos Wilke, Hans, 85599 Parsdorf (DE); Schwarz, Markus, 78199 Bräunlingen (DE); Weisbrod, Erik, 81369 München (DE)
(74) Vertreter: Siemens Patent Attorneys

(57) **Zusammenfassung**

Folgender Gegenstand ist von der Erfindung umfasst: Eine Vorrichtung (1) zur Detektion von Spannungsereignissen (U_det) in einem elektrischen Bauteil umfasst. Ferner ist von der Erfindung ein elektronisches Bauteil (11) umfasst. Ferner ist von der Erfindung ein Verfahren zur Detektion von Spannungsereignissen (U_det) in einem elektronischen Bauteil umfasst. Die Vorrichtung (1) umfasst einen mikroelektromechanischen Aktor (20, 24) und eine Kondensatoranordnung (12), welche Kondensatoranordnung eine erste Elektrode (10) aufweist, welche mit dem elektrischen Bauteil elektrisch verbindbar ist (und im Spannungsereignisfall (U_det) aufgeladen wird) und welcher mikroelektromechanische Aktor (20, 24) eine zweite Elektrode (21, 28) aufweist, welche mit der ersten Elektrode (10) die Kondensatoranordnung (12)bildet, wobei der mikroelektromechanische Aktor (20, 24) mit der zweiten Elektrode (21, 28) relativ zur ersten Elektrode (10) beweglich gelagert angeordnet ist, und unter Einfluss eines elektrostatischen Feldes, welches im Spannungsereignisfall (U_det) in der Kondensatoranordnung (12) erzeugt wird, ausgelenkt wird. Ein Rastermodul (30), in welches der mikroelektromechanische Aktor (20,24) eingreift, wird mittels der Auslenkbewegung des Aktors (20,24) irreversibel eine Raste (32) vorbewegt.

## Beschreibung

Von der Erfindung ist eine Vorrichtung zur Detektion von Spannungsereignissen in einem elektrischen Bauteil umfasst. Ferner ist von der Erfindung ein elektronisches Bauteil umfasst. Ferner ist von der Erfindung ein Verfahren zur Detektion von Spannungsereignissen in einem elektronischen Bauteil umfasst.

Die vorliegende Patentanmeldung befasst sich mit den aktuellen Herausforderungen im Bereich elektronische Baugruppen und deren Alterungsproblemen, insbesondere Überspannungsschäden wie Schäden der Halbleiterbauteile durch Oxiddurchbrüche, Veränderung der Leitfähigkeit der Halbleiterkanäle, Charge Trapping oder Durchbrüche von Isolationsbarrieren und das Aufschmelzen von Leiterbahnen oder des Kristall an sich oder einer graduellen Alterung durch eine Wiederkehrende Überspannungsbelastung insbesondere und Bauteilalterung Bondlifts. Elektronische Baugruppen spielen eine entscheidende Rolle in einer Vielzahl von Anwendungen, von der Unterhaltungselektronik über die Telekommunikation bis hin zur Automobilindustrie. Sie ermöglichen die Verbindung und den reibungslosen Betrieb verschiedener elektronischer Komponenten, die für die Funktion moderner Geräte und Systeme unerlässlich sind.

Trotz ihrer vielfältigen Anwendungen sind elektronische Baugruppen jedoch anfällig für Alterungsprobleme, die ihre Leistungsfähigkeit und Zuverlässigkeit beeinträchtigen können. Vorstehend beschriebene Überspannungsschäden, bei denen die Verbindung zwischen den Komponenten und der Baugruppe schwach wird oder vollständig versagt, gehören zu den häufigsten Problemen, die bei der Alterung elektronischer Baugruppen auftreten können.

Diese Probleme können zu einer Reihe von negativen Folgen führen, darunter Signalverluste, Leistungsabfall, Kurzschlüsse und sogar den vollständigen Ausfall der Baugruppe. Sie können die Lebensdauer elektronischer Geräte erheblich verkürzen und zu kostspieligen Reparaturen oder Austausch führen.

Elektronische Baugruppen sind ein integraler Bestandteil einer Vielzahl von elektronischen Geräten und Systemen, und ihre zuverlässige Funktion ist von entscheidender Bedeutung für die reibungslose Arbeitsweise dieser Technologien.

Trotz der Fortschritte in der Entwicklung von elektronischen Baugruppen sind sie immer noch anfällig für verschiedene Arten von Alterungsproblemen, die ihre Leistungsfähigkeit und Langlebigkeit beeinträchtigen können. Es ist bekannt, dass eine Vielzahl von Faktoren zu Schäden führen kann, von denen einer die Falschbenutzung elektronischer Geräte ist. Insbesondere zu hohe Spannungen, die auf die Baugruppen einwirken, können Alterungsprobleme verstärken und ihre Entstehung begünstigen. Dies kann durch unsachgemäße Handhabung, fehlerhafte Installation oder sogar durch fehlerhafte Konstruktion der elektronischen Geräte selbst verursacht werden.

Ein besonders herausforderndes Problem im Zusammenhang mit elektronischen Baugruppen ist die Möglichkeit von Überspannungen auf der Kundenseite. In vielen Fällen werden diese Module im Feld eingesetzt, was bedeutet, dass die Kontrolle über die Betriebsbedingungen begrenzt ist. Dies kann zu nicht zugelassenen Betriebsarten oder falscher Nutzung führen, die zu Überspannungen führen können. Eine solche Fehlbedienung ist oft schwer nachzuweisen und kann zu erheblichen Schäden an den Baugruppen führen.

Im Falle eines Schadens oder einer Rückläuferanalyse müssen oft das gesamte Produkt und vergleichbare Schadensfälle geprüft werden, um die Ursache der Fehlbedienung nachzuweisen. Dies erfordert einen hohen finanziellen und zeitlichen Aufwand, da eine umfassende Analyse und Prüfung durchgeführt werden muss. Dies ist eine kostspielige Angelegenheit, die die Ressourcen eines Unternehmens stark beansprucht.

Es braucht daher innovative Ansätze und Technologien, um die Auswirkungen von Überspannungen und Fehlbedienungen auf elektronische Baugruppen zu minimieren und ihre Zuverlässigkeit zu verbessern. Durch die Integration von intelligenten Überwachungssystemen soll zunächst die Nachweisbarkeit von Fehlbedienungen erleichtert werden. Die nachfolgenden Abschnitte der Patentanmeldung werden die technischen Details und Vorteile der vorgeschlagenen Lösungen im Detail erläutern. Es wird erwartet, dass die vorgestellte Erfindung einen erheblichen Beitrag zur Weiterentwicklung der elektronischen Baugruppen leisten wird, indem sie den Aufwand bei der Fehlbedienungsnachweisung reduziert.

Die Aufgabe der Erfindung besteht darin, die beschriebenen Probleme im Stand der Technik zu beheben. Beschrieben wird gemäß einem ersten Aspekt der Erfindung eine Vorrichtung zur Detektion von Spannungsereignissen in einem elektrischen Bauteil.

Erfindungsgemäß ist vorgesehen, dass von der Vorrichtung ein mikroelektromechanischer Aktor und eine Kondensatoranordnung umfasst ist, welche Kondensatoranordnung eine erste Elektrode aufweist, welche mit dem elektrischen Bauteil elektrisch verbindbar ist und welcher mikroelektromechanische Aktor eine zweite Elektrode aufweist, welche mit der ersten Elektrode die Kondensatoranordnung bildet, wobei der mikroelektromechanische Aktor mit der zweiten Elektrode relativ zur ersten Elektrode beweglich gelagert angeordnet ist, des Weiteren aufweisend ein Rastermodul, in welches der mikroelektromechanische Aktor derart eingreift, dass im Spannungsereignisfall mittels einer Auslenkbewegung des Aktors irreversibel eine Raste vorbewegt wird.

Die erfindungsgemäße Vorrichtung, bevorzugt als Indikatorchip ausgeführt, ist also derart mit dem auf Falschnutzung zu überwachenden elektrischen Bauteil verbunden, dass die erste Elektrode der Kondensatoranordnung im Spannungsereignisfall elektrisch aufgeladen wird, so dass die zweite Elektrode unter Einfluss eines elektrostatischen Feldes, das im Spannungsereignisfall von der ersten Elektrode erzeugt wird, angezogen wird und dadurch der mikroelektromechanische Aktor ausgelenkt wird. Die Hauptanwendung des erfindungsgemäßen Indikatorchips liegt in der Elektronik und insbesondere in elektronischen Baugruppen. Besonders im Bereich leistungselektronischer Baugruppen ist die Nachweißbarkeit eines derartigen Fehlerereignisses von Vorteil.

Unter einem Rastermodul ist insbesondere ein Zahnmodul zu verstehen, oder die Rasten sind als Ausnehmungen gebildet. Es kann als Rad, Halbrad oder Stange ausgeführt sein. Im vorliegenden Fall wird das Rastermodul bevorzugt stangenförmig gebildet.

Unter einem Aktor wird im Kontext der Anmeldung ein beweglich gelagertes Element verstanden. Der Aktor muss zum Nachweis des Spannungsereignisses in der ausgelenkten Position bleiben. Dafür sorgt die mindestens eine Raste des Rastermoduls, welche als Arretierung dient.

Unter einer Kondensatoranordnung ist eine galvanisch getrennte Elektrodenanordnung zu verstehen. Die erste Elektrode ist elektrisch mit dem zu überwachenden elektrischen Bauteil verbunden. Diese Anbindung kann z.B. über Steckverbindungen oder Lötverbindungen, insbesondere im Fall der Integration auf einer Baugruppe, erfolgen. Die Vorrichtung, also der Indikatorchip, wird beispielsweise in Reihe oder Parallel in die Schaltung des zu überwachenden Bauteils integriert, insbesondere mittels eines bewährten Aufbau- und Verbindungstechnikprozesses.

Ein Vorteil der Erfindung besteht darin, dass ein Nachweis einer oder häufigerer Fehlbedienung möglich ist. Damit kann vermieden werden, dass defekte Module aus Kulanz ausgetauscht oder nur mit Erfahrung begutachtet werden. Eine Überspannung auf der Kundenseite ist somit zuverlässig vom Hersteller nachzuweisen.

Beschrieben wird gemäß einem weiteren Aspekt der Erfindung ein elektronisches Bauteil. Gemäß diesem Aspekt ist erfindungsgemäß vorgesehen, dass das Bauteil eine erfindungsgemäße Vorrichtung zur Detektion von Spannungsereignissen umfasst. Die mit diesem Aspekt der Erfindung verbundenen Vorteile sind vorstehend bereits erläutert worden, wobei auf diese Vorteile verwiesen wird. Der erfindungsgemäße Indikatorchips ermöglicht demnach eine integrierte Rückläuferanalyse und ermöglicht den Nachweis von kundenseitig verursachten Überspannungen, insbesondere durch Fehlbedienungen.

Beschrieben wird gemäß einem weiteren Aspekt der Erfindung ein Verfahren zur Detektion von Spannungsereignissen in einem elektronischen Bauteil. Gemäß diesem Aspekt ist erfindungsgemäß vorgesehen, dass dazu eine erfindungsgemäße Vorrichtung zur Detektion von Spannungsereignissen verwendet wird, welche mit dem elektrischen Bauteil elektrisch verbunden wird. Ein mikroelektromechanischer Aktor wird darin unter Einfluss eines elektrostatischen Feldes, welches im Spannungsereignisfall in einer Kondensatoranordnung erzeugt wird, ausgelenkt wird und ein Rastermodul, in welches der mikroelektromechanische Aktor eingreift, wird mittels der Auslenkbewegung des Aktors irreversibel eine Raste vorbewegt. Die mit diesem Aspekt der Erfindung verbundenen Vorteile sind vorstehend bereits erläutert worden, wobei auf diese Vorteile verwiesen wird.

Weiterbildungen der Erfindung beschreibende Varianten werden nachfolgend ohne Beschränkung des grundlegenden Gedankens der Erfindung erläutert.

Gemäß einer Variante sind die oben erklärten Aspekte der Erfindung dadurch bestimmt, dass das Rastermodul eine Vielzahl an Rasten aufweist und derart beweglich angeordnet ist, dass mittels der Auslenkbewegung des Aktors irreversibel je eine Raste vorbewegt wird. Ein Vorteil dieser Variante besteht darin, dass nicht nur überhaupt ein Spannungsereignis detektiert wird, sondern auch wie viele derartige Spannungsereignisse erfolgten, kann nachgewiesen werden. Das Rastermodul dient also als Zählvorrichtung für Spannungsinsbesondere Überspannungsereignisse.

Demnach ist unter dem Rastermodul im Kontext dieser Anmeldung eine Art Schrittschalter zu verstehen, welcher nur vorwärts- und nicht rückwärtsschaltbar ist. Rasten können Zähne aber auch Ausnehmungen beliebiger Form sein. Zahnelemente können auch als Zapfen oder beliebig geeignet geformte Erhebungen ausgeformt sein. Zähne oder Ausnehmungen sind zweckdienlicherweise so geformt, z.B. angeschrägt, dass die Vorwärtsschaltrichtung durch entsprechende Aktorbewegung angetrieben werden kann, jedoch die Rückwärtsschaltrichtung versperrt bleibt. Das Rastermodul ist dazu mit wenigstens einem Aktor verzahnt angeordnet, d.h. der Aktor greift in wenigstens eine Raste des Rastermoduls ein, z.B. mit einem Zahnelement.

Gemäß einer Variante sind die oben erklärten Aspekte der Erfindung dadurch bestimmt, dass der mikroelektromechanische Aktor als Anker ausgeformt und verkippbar in einer Halterung angeordnet ist. Der Anker ist also um eine Kippachse beweglich gelagert. Der Anker ist zudem bevorzugt mit einer Federelement verbunden. Insbesondere wird Silizium, Siliziumoxid SiOz oder ein Metall im bzw. als Federelement verwendet. Bevorzugt greift der Anker mit seinem Zahnelement von einer ersten Seite in das Rastermodul ein und besonders bevorzugt ist noch ein weiteres Zahnelement an einem Blockierungselement, also an einer Sperre zum Eingreifen in das Rastermodul vorgesehen, welches nur so weit auslenkbar ist, z.B. mittels einer Feder, dass ein Vorrücken des Rastermoduls aber kein Zurückstellen des Rastermoduls möglich ist. Im Kontext dieser Anmeldung bezieht sich der Begriff Anker auf eine Komponente oder ein Bauteil, das verwendet wird, um eine Bewegung, bzw. Kraft zu übertragen. Der Anker dient als fester Bezugspunkt oder Fixpunkt, um die Bewegung anderer Teile oder Komponenten einzuschränken oder zu ermöglichen. Ein Anker kann verschiedene Formen haben, abhängig von der spezifischen Ausgestaltung des Indikatorchips und des Rastermoduls. Der Anker kann mit anderen Komponenten wie Lagern, Kupplungen oder Federn kombiniert werden, um eine reibungslose und kontrollierte Bewegung oder Kraftübertragung zu gewährleisten. Durch seine Funktion als Fixpunkt oder Referenzpunkt spielt der Anker eine wichtige Rolle bei der Stabilität, Steuerung und Effizienz des vorgeschlagenen mikroelektromechanischen Systems.

Gemäß einer Variante sind die oben erklärten Aspekte der Erfindung dadurch bestimmt, der mikroelektromechanische Aktor als Linearaktor ausgeführt und in einer Führung angeordnet ist.

Ein Vorteil dieser Variante besteht darin, dass auch minimale Auslenkungen Rasterzählereignisse bewirken können. Unter einem Linearaktor in einem mikroelektromechanischen System gemäß der Erfindung, ist eine Komponente zu verstehen, die eine lineare Bewegung oder Verschiebung erzeugt. Es handelt sich um einen Aktuator, der in der Lage ist, eine Kraft aufzubringen, um eine lineare Bewegung zu erzeugen. Durch die Anwendung von elektrischen, insbesondere elektrostatischen Kräften kann der Linearaktor die Bewegung von Komponenten in einer geraden Linie steuern oder antreiben. Linearaktoren ermöglichen präzise und kontrollierte lineare Bewegungen auf mikroskopischer Ebene, was für viele mikroelektromechanische Anwendungen von entscheidender Bedeutung ist. Linearaktoren haben den Vorteil, in immer kleineren und leistungsfähigeren Systemen eingesetzt werden zu können, die eine hohe Präzision, Zuverlässigkeit und Effizienz bieten. Durch den Einsatz von Linearaktoren können komplexe Funktionen und Anwendungen in einer kompakten und miniaturisierten Form realisiert werden.

Gemäß einer Variante sind die oben erklärten Aspekte der Erfindung dadurch bestimmt, dass wenigstens eine der Elektroden als Fingerelektrode ausgebildet ist.

Ein Vorteil dieser Variante besteht darin, dass Fingerelektrodenstrukturen gegenüber flächigen Elektrodenstrukturen, insbesondere im Fall einer Kondensatoranordnung, eine erhöhte effektive Oberfläche aufweisen. Fingerelektrodenstrukturen bestehen aus dünnen, parallel angeordneten elektrischen Leiterbahnen, die wie Finger aussehen. Im Gegensatz dazu sind flächige Elektrodenstrukturen kontinuierliche, ebene Leiterbahnen. Durch die Verwendung von Fingerelektrodenstrukturen kann die effektive Oberfläche eines Kondensators erheblich erhöht werden. Dies führt zu einer größeren Kapazität des Kondensators und damit zu einer verbesserten Leistungsfähigkeit, oder in diesem Fall zu einer zuverlässigeren Auslenkung des Aktors und sensibleren Detektion eines Spannungsereignisses.

Ein weiterer Vorteil von Fingerelektrodenstrukturen ist ihre geringere parasitäre Induktivität. Da die Fingerstrukturen in der Regel kürzer sind als flächige Elektrodenstrukturen, wird der elektrische Strompfad verkürzt, was zu einer geringeren Induktivität führt. Dies ist besonders wichtig in Anwendungen, in denen schnelle Schaltgeschwindigkeiten oder hohe Frequenzen erforderlich sind. Darüber hinaus ermöglichen Fingerelektrodenstrukturen eine verbesserte Ausnutzung des zur Verfügung stehenden Platzes. Durch die Anordnung der Finger in einem Muster können mehr Fingerstrukturen in einem begrenzten Bereich untergebracht werden, was zu einer höheren Kapazitätsdichte führt. Insgesamt bieten Fingerelektrodenstrukturen gegenüber flächigen Elektrodenstrukturen in Kondensatoranordnungen eine größere effektive Oberfläche, eine geringere parasitäre Induktivität und eine höhere Kapazitätsdichte. Diese Vorteile machen sie zu einer bevorzugten Wahl in vielen Anwendungen, bei denen hohe Kapazitäten und verbesserte Leistungsfähigkeit gefordert sind.

Gemäß einer weiteren Variante sind die oben erklärten Aspekte der Erfindung dadurch bestimmt, dass beide Elektroden der Kondensatoranordnung als Fingerelektroden ausgebildet sind.

Gemäß einer zweckdienlichen Variante der Erfindung sind die oben erklärten Aspekte der Erfindung dadurch bestimmt, dass wenigstens eine mechanische Rückstelleinrichtung, insbesondere eine Feder, umfasst ist.

Dies bewirkt eine zuverlässige Rückkehr des Aktors in seine Ausgangslage vor dem Spannungsereignis. Dabei können die Federn, je nach Anordnung, vorgespannt oder vorgestaucht vorliegen und je nach Anwendung und Aufbau des Rastermoduls die Auslenk- und/oder die Rückstellbewegung unterstützen.

Beschrieben wird gemäß einem weiteren Aspekt der Erfindung ein Verfahren zur Detektion von Spannungsereignissen in einem elektronischen Bauteil und gemäß einer Variante davon sind die oben erklärten Aspekte der Erfindung dadurch bestimmt, dass eine erfolgte Auslenkung und/oder die Anzahl der erfolgten Auslenkungen festgestellt wird, insbesondere nach einem Feldrücklauf.

Ein Vorteil dieser Variante besteht darin, dass nicht nur ein Fehlerereignis nachgewiesen werden kann, sondern eine Zählung von Fehlbedienungen erfolgen kann.

Gemäß einer zweckdienlichen Variante sind die oben erklärten Aspekte der Erfindung dadurch bestimmt, dass mittels einer Sichtprüfung eine erfolgte Auslenkung und/oder die Anzahl der erfolgten Auslenkungen festgestellt wird. Diese kann beispielsweise mittels eines Mikroskops erfolgen.

Ein Vorteil dieser Variante besteht darin, dass dieser Nachweis auch bei Stromausfall geführt werden kann. Im Gegensatz zu softwaretechnischen Ansätzen ist es möglich, einen solchen Nachweis auch bei abgeschalteter Elektronik zu führen.

Gemäß einer weiteren sind die oben erklärten Aspekte der Erfindung dadurch bestimmt, dass mittels eines bildgebenden Verfahrens eine erfolgte Auslenkung und/oder die Anzahl der erfolgten Auslenkungen festgestellt wird. Dies kann insbesondere mittels Infrarotinspektion oder mittels einer Röntgenbildgebung erfolgen.

Gemäß einer vorteilhaften Variante sind die oben erklärten Aspekte der Erfindung dadurch bestimmt, dass mittels eines elektrischen Messverfahrens eine erfolgte Auslenkung und/oder die Anzahl der erfolgten Auslenkungen festgestellt wird. Dazu können Widerstandsmessung, Kapazitätsmessung, Frequenzanalyse, u.a. herangezogen werden. Ein Vorteil davon ist, dass diese Prüfung nicht am geöffneten Bauteil erfolgen muss.

Gemäß einer sehr vorteilhaften Variante sind die oben erklärten Aspekte der Erfindung dadurch bestimmt, dass das Spannungsereignis eine Überspannung ist. Unter einer Überspannung im Kontext der Anmeldung ist eine Spannung U > Uₘₐₓ zu verstehen, welche also über einer maximal im Betrieb zulässige Spannung Uₘₐₓ liegt. Diese maximal zulässige Spannung kann vom Hersteller bestimmt werden. Insbesondere ist die Maximalspannung Uₘₐₓ so eingestellt, dass das Bauteil eine möglichst lange Lebensdauer hat, wenn die Betriebsspannung U stets unter diesem Schwellwert bleibt.

Gemäß einer alternativen Variante sind die oben erklärten Aspekte der Erfindung dadurch bestimmt, dass das Spannungsereignis eine Unterspannung, insbesondere Spannungsunterbrechung ist. Unter einer Unterspannung im Kontext der Anmeldung ist eine Spannung U < Uₘᵢₙ zu verstehen, welche also unter einer minimal im Betrieb erforderliche Spannung Uₘᵢₙ liegt. Mittels dieser Methode können beispielsweise Spannungsunterbrechungen im Betrieb nachgewiesen werden, welche auch lebensdauerschädliche Wirkung haben können. Exemplarische Ausführungsbeispiele der Zeichnung

Weitere Einzelheiten der Erfindung werden nachfolgend anhand der Zeichnung beschrieben. Gleiche oder sich entsprechende Zeichnungselemente sind in den einzelnen Figuren jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Varianten der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Komponenten auch mit den vorstehend beschriebenen Varianten der Erfindung kombinierbar.

Unabhängig vom grammatikalischen Geschlecht betreffender Begriffe sind Personen mit männlicher, weiblicher oder anderer Geschlechtsidentität gleichermaßen umfasst.
- Figur 1: zeigt eine erste Variante eines Indikatorchips 1, beziehungsweise schematisch die mikroelektromechnische Anordnung von Kondensatoranordnung 12, Anker 20 und Rastermodul 30.
- Figur 2: zeigt eine zweite Variante eines Indikatorchips 1, beziehungsweise schematisch die mikroelektromechnische Anordnung von Kondensatoranordnung 12, Linearaktor 24 und Rastermodul 30.
- Figur 3: zeigt eine Variante eines Indikatorchips 1 für Unterspannungsdetektion, beziehungsweise schematisch die mikroelektromechnische Anordnung von Kondensatoranordnung 12, Linearaktor 24 und Rastermodul 30.

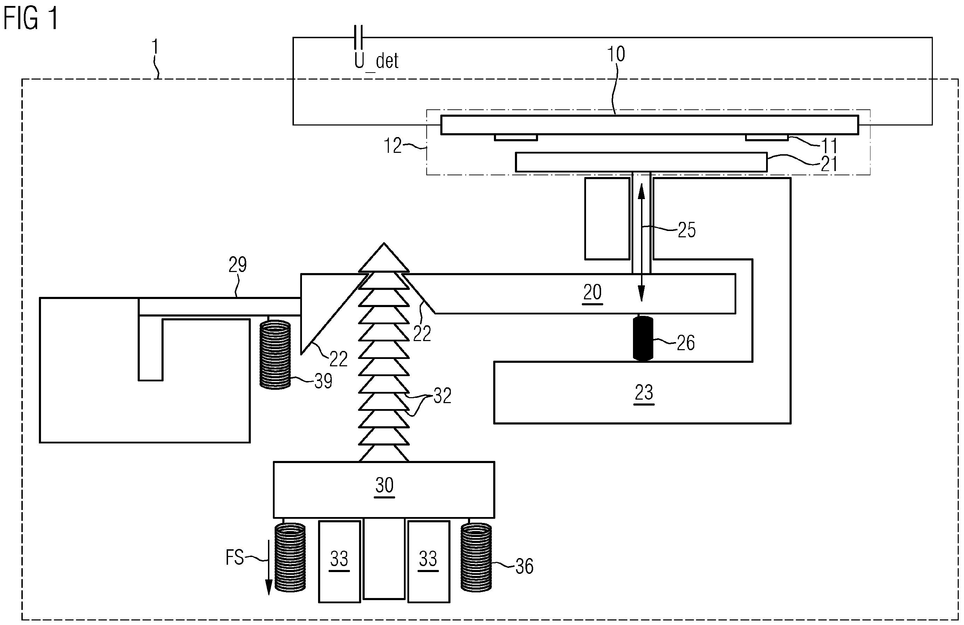

Damit im Schadensfall eine verlässliche Rückläuferanalyse durchgeführt werden kann, wird in ein elektrisches Produkt ein Indikatorchip 1 eingebracht, entsprechend der erfindungsgemäßen Vorrichtung 1. Dieser Indikatorchip 1 kann als passiver MEMS-Überspannungssensor, zur Detektion von Fehler-Events ausgebildet sind. Einen entsprechenden Aufbau schematisch und nicht maßstabsgetreu dargestellt, zeigt die Figur 1. Eine Überspannung U_det > Uₘₐₓ kann durch einen elektrostatischen Aktor, in dieser Darstellung ein Anker 20, detektiert werden. Durch ein Zahnstangen-Design 30 wird zusätzlich auch die Anzahl der Überspannungs-Events U_det > Uₘₐₓ gezählt. Die Gateelektrode 10 zieht den Anker 20 an. Dieser kann maximal bis zu den Abstandshaltern 11 auf der Gateelektrode auslenken. Die Zahnstange 30 wird durch die Sperre 29 gehalten. Bei jedem Event wird die Zahnstange 30 um ein Rasterelement 32 weiterbewegt.

Der Anker 20 wird in einer Halterung 23 positioniert, wo er kippbar gelagert ist. Ein Rückstellelement, im gezeigten Beispiel eine Feder 26, sorgt für die Rückkehr in die Ausgangsposition nach dem Spannungsevent. Im gezeigten Beispiel ist eine ebenso mit Federelement 39 gehaltene Sperre 29 vorgesehen, die ein Zurückstellen des Rastermoduls 30 verhindert. Auch die zahnförmigen Rasten 32 sind vorteilhaft, um nur die Vorwärtsstellrichtung des Rastermoduls 30 zu ermöglichen. Das Rastermodul 30 kann beispielsweise in einer Linearführung 33 angeordnet sein. Es kann durch Federn 36 zusätzlich in Rückwärtsstellrichtung gedrückt werden. Dies verhindert ein Verstellen durch Vibration, Schock oder beispielsweise Gravitation. In der Figur 1 ist eine Federkraft Fs mit einem Pfeil neben der Feder 36 angedeutet. Des Weiteren ist die Auslenkbewegung des Ankers 20 mit einem Pfeil 25 angezeigt. Sperre 29 und Anker 20 weisen zum Eingreifen in das Rastermodul 30 bevorzugt Zahnelemente 22 auf, welche idealerweise an die Form der Rasten 32 angepasst sind, z.B. einseitig angeschrägt.

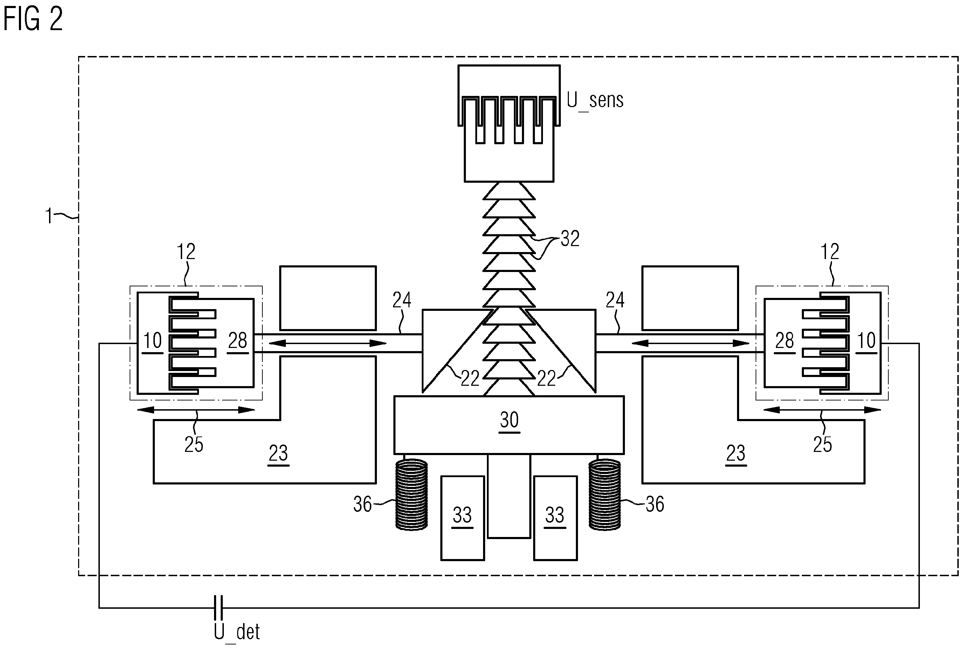

Eine weitere Möglichkeit ist ein vorgespannter Detektor 1, wie er in Figur 2 gezeigt ist. Dieser kann dann durch die Überspannung U_det > Uₘₐₓ ausgelöst werden. In der Figur 2 ist ein Linearaktor 24 gezeigt, der in einer Führung 23 beweglich gelagert ist. Insbesondere können zwei Linearaktoren 24 beidseitig in das Rastermodul 30 eingreifen. Auch im vorliegenden Fall weisen die Aktoren 24 Zähne 22 zum Eingreifen in die Rasten 32 auf. Die Bewegungsrichtung der Aktoren 24 ist wiederum mit Pfeilen 25 angezeigt. Die Kondensatoranordnung 12 weist in dieser Variante Fingerelektroden 10, 28 auf.

Die erfolgte Auslösung, also ein Weiterrücken des Rastermoduls 30, kann später durch folgende Mechanismen erkannt werden, insbesondere durch Sichtprüfung, insbesondere mittels eines Mikroskops, mittels Widerstandsmessung, z.B. über einen elektrischen Kontakt der Zahnstange 30 mit einem anderen Bauelement, oder Kapazitätsmessung nach der Auslösung mittels einer U_sens-Vorbereitung, wie sie auch in der Figur 2 dargestellt ist. Zum Nachweis einer Auslösung des Indikatorchips 1 kann eine Messung des Gesamtwiderstandes, eine Infrarot-Inspektion mit IR-Bild, eine RF-Frequenzanalyse des Bauteils oder eine Positionsbestimmung mittels Röntgenbild erfolgen.

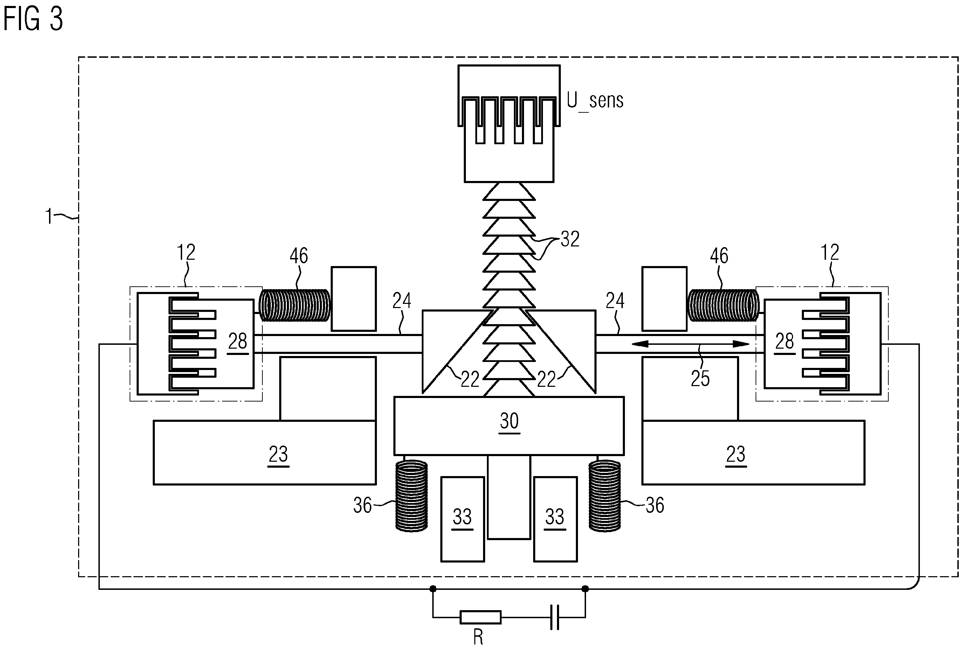

In der Figur 3 ist noch eine Anordnung gezeigt, mittels der eine Spannungsunterbrechung nachgewiesen werden kann. Eine Unterbrechung der Spannung ist unter anderem für eine Detektion von tiefenentladenen Batterien sinnvoll. Dabei wird die mikroelektromechnische Detektoranordnung 1 bei nicht ausreichender Spannung U < Uₘᵢₙ ausgelöst. In der Figur 3 ist ein Detektor 1 dargestellt, der Unterspannung detektieren soll. Dabei werden die Aktoren 24 durch eine anliegende elektrische Spannung U > Uₘᵢₙ an die Zahnstange 30 gedrückt. Unterschreitet die Spannung U einen gewissen Wert Uₘᵢₙ, schnellen die Aktoren 24 zurück und die Zahnstange 30 drückt auf die unteren Kontakte. Dieses Auslösen kann z.B. durch eine Widerstandsmessung R detektiert werden.

Der Indikatorchip 1 kann vorteilhaft Anwendung finden für eine Rückläuferanalyse, besonders vorteilhaft auch im Schadensfall, wenn es um Garantie oder Gewährleistung geht, bei Begutachtung von Leasingrückläufern, bei Auswertung bezüglich eines Bedarfs, insbesondere Reparaturbedarf oder Wiederverwertungsbedarf. Er kann sinnvoll eingesetzt werden, um eine Unterstützung der Kunden bei der Auffindung kritischer Betriebszustände zu ermöglichen oder dem Kunden eine Fehlbenutzung anzuzeigen, insbesondere außerhalb der Spezifikation. Darüber hinaus kann der Chip 1 als Fälschungsnachweis herangezogen werden.

Alternativ kann die Funktionsweise genutzt werden, um eine Unterbrechung der Spannung zu detektieren. Ein Blackout kann angezeigt oder nachgewiesen werden. Eine Batterie kann auf Tiefenentladung geprüft werden.

Das Bauelement benötigt keine Software und keine zusätzlichen Speicherelemente oder eine separate Spannungsversorgung. Es kann daher die bestimmungsgemäße Nutzung bei der spezifizierten Spannung dokumentieren.

### Bezugszeichen:

- 1: Indikatorchip
- 10: Gateelektrode

- U_det: zu detektierende Spannung
- 11: Abstandshalter/Isolatoren
- 12: Kondensatoranordnung

- 20: Anker
- 21: Kapazität/Elektrode
- 22: Zahn/Rasterelement
- 23: Anker- bzw. Aktorbefestigung, -führung
- 24: Aktor
- 25: Auslenkungsbewegung, Aktorbewegung
- 26: Feder
- Fs: Federkraft
- 27: Fingerelektrode
- 28: Sperre

- 30: Rastermodul, insb. Zahnstange
- 32: Zahn/Rasterelement
- 33: Führung, Befestigung
- 36: Feder zur Vorspannung
- 39: Feder
- U_sens: Sensorvorspannung
- R: Widerstandsmessung
- 46: Feder

## Patentansprüche

1. Vorrichtung (1) zur Detektion von Spannungsereignissen (U_det) in einem elektrischen Bauteil, **dadurch gekennzeichnet, dass** ein mikroelektromechanischer Aktor (20, 24) und eine Kondensatoranordnung (12) umfasst ist, welche Kondensatoranordnung eine erste Elektrode (10) aufweist, welche mit dem elektrischen Bauteil elektrisch verbindbar ist (und im Spannungsereignisfall (U_det) aufgeladen wird) und welcher mikroelektromechanische Aktor (20, 24) eine zweite Elektrode (21, 28)aufweist, welche mit der ersten Elektrode (10) die Kondensatoranordnung (12)bildet, wobei der mikroelektromechanische Aktor (20, 24) mit der zweiten Elektrode (21, 28) relativ zur ersten Elektrode (10) beweglich gelagert angeordnet ist, des Weiteren aufweisend ein Rastermodul (30), in welches der mikroelektromechanische Aktor (20,24) derart eingreift, dass im Spannungsereignisfall (U_det) mittels einer Auslenkbewegung des Aktors (20,24)irreversibel eine Raste (32) vorbewegt wird.

2. Vorrichtung (1) nach Anspruch 1, **dadurch gekennzeichnet, dass** das Rastermodul (30) eine Vielzahl an Rasten (32) aufweist und derart beweglich angeordnet ist, dass mittels der Auslenkbewegung des Aktors (20,24) irreversibel je eine Raste (32) vorbewegt wird.

3. Vorrichtung (1) nach Anspruch 1 oder 2, **dadurch gekennzeichnet, dass** der mikroelektromechanische Aktor als Anker (20) ausgeformt und verkippbar in einer Halterung (23) angeordnet ist.

4. Vorrichtung (1) nach einem der vorhergehenden Ansprüche, **dadurch gekennzeichnet, dass** der mikroelektromechanische Aktor (24) als Linearaktor (24) ausgeführt und in einer Führung (33) angeordnet ist.

5. Vorrichtung (1) nach einem der vorhergehenden Ansprüche, **dadurch gekennzeichnet, dass** wenigstens eine der Elektroden (10, 21, 28) als Fingerelektrode ausgebildet ist.

6. Vorrichtung (1) nach einem der vorhergehenden Ansprüche, **dadurch gekennzeichnet, dass** beide Elektroden (10, 21, 28) der Kondensatoranordnung (12) als Fingerelektroden ausgebildet sind.

7. Vorrichtung (1) nach einem der vorhergehenden Ansprüche, **dadurch gekennzeichnet, dass** wenigstens eine mechanische Rückstelleinrichtung (26, 36), insbesondere eine Feder, umfasst ist.

8. Elektronisches Bauteil (11) **dadurch gekennzeichnet, dass** es eine Vorrichtung (1) nach einem der Ansprüche 1 bis 7 umfasst.

9. Verfahren zur Detektion von Spannungsereignissen (U_det) in einem elektronischen Bauteil **dadurch gekennzeichnet, dass** dazu eine Vorrichtung (1) nach einem der Ansprüche 1 bis 7 verwendet wird, welche mit dem elektrischen Bauteil elektrisch verbunden wird, in dem ein mikroelektromechanischer Aktor (20, 24) unter Einfluss eines elektrostatischen Feldes, welches im Spannungsereignisfall (U_det) in einer Kondensatoranordnung (12) erzeugt wird, ausgelenkt wird und ein Rastermodul (30), in welches der mikroelektromechanische Aktor (20,24) eingreift, mittels der Auslenkbewegung des Aktors (20,24) irreversibel eine Raste (32) vorbewegt wird.

10. Verfahren nach Anspruch 9, **dadurch gekennzeichnet, dass** eine erfolgte Auslenkung und/oder die Anzahl der erfolgten Auslenkungen festgestellt wird, insbesondere nach einem Feldrücklauf.

11. Verfahren nach Anspruch 10, **dadurch gekennzeichnet, dass** mittels einer Sichtprüfung eine erfolgte Auslenkung und/oder die Anzahl der erfolgten Auslenkungen festgestellt wird.

12. Verfahren nach einem der Ansprüche 10 oder 11, **dadurch gekennzeichnet, dass** mittels eines bildgebenden Verfahrens eine erfolgte Auslenkung und/oder die Anzahl der erfolgten Auslenkungen festgestellt wird.

13. Verfahren nach einem der Ansprüche 10 bis 12, **dadurch gekennzeichnet, dass** mittels eines elektrischen Messverfahrens eine erfolgte Auslenkung und/oder die Anzahl der erfolgten Auslenkungen festgestellt wird.

14. Verfahren nach einem der Ansprüche 9 bis 13, **dadurch gekennzeichnet, dass** das Spannungsereignis eine Überspannung ist.

15. Verfahren nach einem der Ansprüche 9 bis 13, **dadurch gekennzeichnet, dass** das Spannungsereignis eine Unterspannung, insbesondere Spannungsunterbrechung ist.
